(19)

Europäisches
Patentamt
European
Patent Office
Office européen
des brevets

(11)     **EP 2 442 368 A2**

(12)                        **EUROPEAN PATENT APPLICATION**

(43) Date of publication:
**18.04.2012 Bulletin 2012/16**

(51) Int Cl.:
*H01L 31/0288* (2006.01)     *H01L 31/068* (2012.01)

(21) Application number: **11008373.0**

(22) Date of filing: **18.10.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **18.10.2010   KR 20100101512**

(71) Applicant: **LG ELECTRONICS INC.**
**Yeongdeungpo-gu**
**Seoul 150-721 (KR)**

(72) Inventors:
• **Shim, Seunghwan**
**Seocho-Gu**
**Seoul 137-724 (KR)**
• **Kim, Jinah**
**Seocho-Gu**
**Seoul 137-724 (KR)**
• **Nam, Jeongbeom**
**Seocho-Gu**
**Seoul 137-724 (KR)**

• **Chung, Indo**
**Seocho-Gu**
**Seoul 137-724 (KR)**
• **Yang, Juhong**
**Seocho-Gu**
**Seoul 137-724 (KR)**
• **Choi, Hyungwook**
**Seocho-Gu**
**Seoul 137-724 (KR)**
• **Jung, Ilhyoung**
**Seocho-Gu**
**Seoul 137-724 (KR)**
• **Kwon, Hyungiin**
**Seocho-Gu**
**Seoul 137-724 (KR)**

(74) Representative: **Katérle, Axel**
**Wuesthoff & Wuesthoff**
**Patent- und Rechtsanwälte**
**Schweigerstraße 2**
**81541 München (DE)**

(54)     **Semiconductor substrate for solar cell and solar cell**

(57)     A solar cell include a polycrystalline semiconductor substrate of a p-type, an emitter region of an n-type and forming a p-n junction with the polycrystalline semiconductor substrate, a first electrode connected to the emitter region, and a second electrode connected to the polycrystalline semiconductor substrate, wherein the polycrystalline semiconductor substrate has a pure p-type impurity concentration of substantially $7.2 \times 10^{15}/cm^3$ to $3.5 \times 10^{16}/cm^3$.

**FIG. 3**

**EP 2 442 368 A2**

**Description**

## BACKGROUND OF THE INVENTION

**(a) Field of the Invention**

Embodiments of the invention relate to a semiconductor substrate for a solar cell and the solar cell.

**(b) Description of the Related Art**

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts that have different conductive types, such as a p-type and an n-type, and form a p-n junction, and electrodes respectively connected to the semiconductor parts of the different conductive types.

When light is incident on the solar cell, a plurality of electron-holes pairs are generated in the semiconductor parts. By a p-n junction, the electrons move to the n-type semiconductor part and the holes move to the p-type semiconductor part, and then the electrons and holes are collected by the electrodes electrically connected to the n-type semiconductor part and the p-type semiconductor part, respectively. The electrodes are connected to each other using electric wires to thereby obtain electric power.

## SUMMARY OF THE INVENTION

According to an aspect of the invention, a semiconductor substrate for a solar cell made of a semiconductor of a p-type includes a first impurity of the p-type, a second impurity of the p-type, and a third impurity of an n-type, wherein a pure p-type impurity concentration of the semiconductor substrate is substantially $7.2 \times 10^{15}$/ cm$^3$ to $3.5 \times 10^{16}$/cm$^3$ and wherein the pure impurity concentration is obtained by subtracting a concentration of the third impurity from a sum of a concentration of the first impurity and a concentration of the second impurity.

The concentration of the second impurity may be substantially $1 \times 10^{13}$/cm to $5.5 \times 10^{15}$/cm$^3$.

The sum of the concentration of the first impurity and the concentration of the second impurity may be sub-stantially $3.5 \times 10^{16}$/cm$^3$ or less.

The concentration of the third impurity may be substantially $2.8 \times 10^{16}$/cm$^3$ or less.

The first impurity may be boron (B), and the second impurity may be at least one of the aluminum (Al) and gallium (Ga), and the third impurity may be phosphorus (P).

The semiconductor substrate may be a polycrystalline silicon substrate.

The semiconductor substrate may further include iron (Fe).

The concentration of the iron (Fe) may be substantially $6 \times 10^{15}$/cm$^3$ or less.

According to another aspect of the invention, a solar cell includes a polycrystalline semiconductor substrate of a p-type, an emitter region of an n-type and forming a p-n junction with the polycrystalline semiconductor substrate, a first electrode connected to the emitter region, and a second electrode connected to the polycrystalline semiconductor substrate, wherein the polycrystalline semiconductor substrate has a pure p-type impurity concentration of substantially $7.2 \times 10^{15}$/cm$^3$ to $3.5 \times 10^{16}$/cm$^3$.

The solar cell may have a breakdown voltage of substantially 12V to 41 V.

The polycrystalline semiconductor substrate may contain boron (B), at least one of aluminum (Al) and gallium (Ga), and phosphorous (P).

The concentration of the aluminum (Al) may be substantially $1 \times 10^{13}$/cm$^3$ to $5.5 \times 10^{15}$/cm$^3$.

A sum of a concentration of boron (B) and a concentration of at least one of aluminum (Al) and gallium (Ga) may be substantially $3.5 \times 10^{16}$/cm$^3$ or less.

The concentration of the phosphorus (P) may be substantially $2.8 \times 10^{16}$/cm$^3$ or less.

The polycrystalline semiconductor substrate may further include iron (Fe).

The concentration of the iron (Fe) may have a concentration of substantially $6 \times 10^{15}$/cm$^3$ or less.

The polycrystalline semiconductor substrate may include a first impurity of the p-type, a second impurity of the p-type, and a third impurity of the n-type, wherein the pure impurity concentration may be obtained by subtracting a concentration of the third impurity from a sum of a concentration of the first impurity and a concentration of the second impurity.

The concentration of the second impurity may substantially $1 \times 10^{13}$/cm$^3$ to $5.5 \times 10^{15}$/cm$^3$.

The sum of the concentration of the first impurity and the concentration of the second impurity may be sub-

stantially $3.5 \times 10^{16}$/cm$^3$ or less, and the concentration of the third impurity is substantially $2.8 \times 10^{16}$/cm$^3$ or less.

The first impurity may be boron (B), the second impurity may be at least one of aluminum (Al) and gallium (Ga), and the third impurity may be phosphorus (P).

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a graph showing a reverse-bias voltage according to a variation of a pure impurity concentration of impurities contained in a substrate;

FIG. 2 is a partial perspective view of a solar cell according to an example embodiment of the invention; and

FIG. 3 is a cross-sectional view taken along line III-III of FIG. 2

## DETAILED DESCRIPTION OF THE EMBODIMENTS

The invention will be described more fully hereinafter with reference to the accompanying drawings, in which example embodiments of the inventions are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

First, a substrate, that is, a semiconductor substrate, for a solar cell according to the embodiment is described.

A semiconductor substrate of a general solar cell includes a p-type semiconductor portion and an n-type semiconductor portion to form a p-n junction, and electrodes are connected to the p-type and n-type semiconductor portions of the semiconductor structure, respectively. Then, when light is incident on the semiconductor substrate, a plurality of electron-holes pairs are generated and the electrons and holes move to electrodes due to the p-n junction Thereby, the electrons and holes are outputs to the electrodes to obtain electric power. In this instance, a voltage obtained by one solar cell is generally about 0.6V. The semiconductor substrate for the solar cell is a single crystal silicon substrate or a polycrystalline silicon substrate.

In general, the solar cells generating electricity using irradiated light are arranged in a matrix structure, for example, a $10 \times 6$ matrix structure, and the solar cells of the predetermined number (for example, 60) are electrically connected in series to each other to form one solar cell module. Thereby, at least one solar cell module is installed in a space to construct a photovoltaic system.

When in some of the installed solar cell modules, light is not normally incident onto at least one solar cell or a shade is generated in at least one solar cell by the clouds, the leaves, or the dusts, etc., each of the voltage and the current generated from the at least one solar cell does not have a normal magnitude and is thereby less than the normal magnitude. Hereinafter, the solar cell not generating the voltage and current of the normal magnitude is referred to as an abnormal solar cell, and a solar cell which normally receives light onto the entire incident surface thereof and generates the voltage and current of normal magnitudes is referred to as a normal solar cell. When at least one abnormal solar cell exists in a solar cell module, a sum of voltages generated from the remaining normal solar cells is applied to the at least one abnormal solar cell as a reverse-bias voltage.

Thus, a reverse current based on the reverse-bias voltage flows through the abnormal solar cell supplied with the reverse-bias voltage, and when the reverse-bias voltage exceeds a threshold voltage, that is, a breakdown voltage, the reverse current flowing through the abnormal current rapidly increases. In this instance, the phenomenon of rapid increment (or increase) of the reverse current is referred to as a breakdown phenomenon.

As described above, when the reverse current flows through a solar cell, heat is generated in the solar cell to deteriorate the solar cell and to thereby reduce the efficiency and the lifetime of the solar cell. Accordingly, power generated from the solar cell module also decreases.

A magnitude of the breakdown voltage causing the rapid increment (or increase) of the reverse current is varied in accordance with concentrations of impurities contained in the substrate, that is, the semiconductor substrate, of the solar cell.

For protecting the at least one abnormal solar cell and the solar cell module that includes the at least one abnormal solar cell from the reverse-bias voltage, the solar cell module includes at least one bypass diode.

However, in a commercial solar cell module, one bypass diode is not installed for every one solar cell, but rather, one bypass diode is installed for every two solar cell columns that are adjacent to each other, and therefore, one bypass diode is installed for a pair of solar cell columns. For example, when the plurality of solar cells are arranged in a 10×6 matrix structure, for example, the total number of the bypass diodes is 3. Thereby, the number of solar cells protected by one bypass diode is, for example, 20, which is the entire number of solar cells existing in two solar cell columns.

Thus, in one solar cell column in which a plurality of solar cells are connected in series, when the number of the abnormal solar cell is one, a voltage of a magnitude corresponding to a sum of voltages generated from the remaining normal solar cells is applied to the abnormal solar cell as a reverse-bias voltage.

For example, when 20 solar cells each of which outputs a voltage of about 0.6V in a normal state are connected in series in two solar cell columns and one of 20 solar cells is a abnormal solar cell, a magnitude of a reverse-bias voltage applied to the one abnormal solar cell is about 11.4V (= 0.6V×19 solar cells) because a voltage outputted from each normal solar cell is about 0.6V. Accordingly, in this instance, all of the voltages outputted from 19 solar cells among the total of 20 solar cells protected by one bypass diode are applied to the one abnormal solar cell as the reverse voltage. Thus, in the solar cell module of the 10×6 matrix structure, the maximum reverse bias-voltage to be applied to each solar cell is about 11.4V. Although discussed in terms of a 10×6 matrix structure, embodiments of the invention may include a varying number of matrix structures.

The breakdown phenomenon of the solar cell due to the reverse-bias voltage is varied depending on concentrations of impurities in the substrate and an internal field in a depletion layer generated from the p-n junction. The internal field increases further as application and increment of the reverse bias voltage occurs, and thereby, by generating the tunneling phenomenon and the avalanche breakdown phenomenon of electrons from the p-type substrate, rapid reverse current increment at a specific reverse-bias voltage is caused.

A substrate for manufacturing the solar cell contains impurities in a raw material (for example, $SiO_2$) for manufacturing a semiconductor wafer to be used as the substrate for the solar cell or impurities [for example, phosphorus (P), aluminum (Al), gallium (Ga), iron (Fe), etc.] doped for improving characteristics of the substrate as well as an impurity [for example, boron (B)] artificially doped for a p-type conductivity.

When the substrate of the solar cell is of a p-type, boron (B) and at least one of aluminum (Al) and gallium (Ga) is a p-type impurity that is of the same conductivity type as the substrate, and phosphorus (P) is an n-type impurity that is of an opposite conductivity type as the substrate. Thus, a concentration of the p-type impurity in the p-type substrate is changed or modified by the presence of the n-type impurity. If desired, gallium (Ga) need not be injected (or included) in the substrate. Thus, when gallium (Ga) is injected (or included) in the substrate, the p-type impurities are boron (B), aluminum (Al) and gallium (Ga), but when gallium (Ga) is not injected (or included) in the substrate, the p-type impurities are boron (B) and aluminum (Al).

As described above, the breakdown voltage of the substrate for the solar cell is influenced by the internal field from the p-n junction of the substrate (which is a p-type) and an emitter region (which is an n-type). As the concentration of the p-type impurity increases, an initial internal field (that is, an internal field when the reverse-bias voltage is 0V) increases, and when a reverse-bias voltage is applied to the substrate for the solar cell in a state that the initial internal field is increasing, the depletion layer due to the p-n junction further increases.

That is, when the reverse-bias voltage is applied to the solar cell, a (+) voltage is applied to the n-type emitter region that is positioned towards a front surface of the p-type substrate, on which light is incident, and a (-) voltage is applied to a back surface of the p-type substrate, which is positioned opposite to the front surface of the substrate.

Thus, electrons (e-) move toward the emitter region by the (+) voltage applied to the emitter region, and holes (h+) move toward the back surface of the substrate by the (-) voltage applied to the back surface of the substrate, and thereby, the depletion layer in the p-n junction further increases when the reverse-bias voltage is applied to the solar cell. When the depletion layer increases, the internal field of the substrate for the solar cell also increases, and thereby, when a magnitude of the reverse-bias voltage applied to the solar cell reaches a specific threshold value, the breakdown phenomenon occurs.

Thereby, elements that affect the reverse-bias voltage of the solar cell are impurity concentrations, and the internal field of the substrate from the p-n junction.

In the embodiment, by increasing a magnitude of the breakdown voltage of the substrate for the solar cell, which is a p-type polycrystalline silicon substrate, for example, to about 12V and more, even though the largest reverse-bias voltage (the maximum reverse-bias voltage) (e.g,. about 11.4V) is applied to a solar cell of a solar cell module, it prevents or reduces the occurrence of the breakdown phenomenon.

As described, since the magnitude of the breakdown voltage is affected by the impurity concentrations of the substrate, the impurity concentrations of the substrate which has been sliced from the ingot for the solar cell is controlled considering the influence of the internal field due to the variation of the depletion layer in the forming of the p-n junction.

In this instance, the magnitude of the breakdown voltage of the substrate is controlled in consideration of not only the concentration of boron, which is a p-type impurity, injected (or included) for obtaining the conductivity type of the substrate, but also the concentrations of the impurities, that is, phosphorous (P) which is an n-type impurity, and at least one of aluminum (Al) and gallium (Ga) which are also p-type impurities. The phosphorous (P), aluminum (Al) and gallium (Ga) are contained (or included) in the raw material of the substrate, as described.

Thus, the impurity concentration Ct of the substrate (sliced from the ingot) that affects the p-type of the substrate is controlled in consideration of all of a concentration C1 of the p-type impurity such as boron (B), a concentration C2 of the n-type impurity such as phosphorus (P), and a concentration C3 of at least one of aluminum (Al) and gallium (Ga) which are p-type impurities.

The impurity concentration Ct of the substrate that affects the p-type of the substrate is obtained by subtracting the concentration C2 of the n-type impurity [phosphorous (P)] from the total concentration (C1+C3) of the p-type impurities, that is, a sum (C1+C3) of the concentration C1 of boron (B) and the concentration C3 of at least one of aluminum (Al) and gallium (Ga). Thereby, Ct = (C1+C3)-C2. In this instance, the impurity concentration [Ct = (C1+C3)-C2] of the p-type substrate in consideration of all of the p-type impurities and the n-type impurity is referred to as 'a pure impurity concentration.' That is, the pure impurity concentration is a pure p-type impurity concentration. In another word, the pure impurity concentration is an effective purity of the p-type impurities.

As a result, the increment of the pure p-type impurity concentration Ct increase the internal field into the depletion layer of the p-n junction, and when the reverse-bias voltage is applied to the substrate for the solar cell, the internal field largely or greatly increases to cause the breakdown phenomenon.

In the embodiment of the invention, a changed reference voltage (about 12V) of the breakdown voltage is a value for preventing the occurrence of the breakdown phenomenon even though the largest reverse-bias voltage (about 11.4V) capable of being applied to one solar cell is applied to one abnormal solar cell of a solar cell module which includes a plurality of solar cells arranged in the 10×6 matrix structure. Accordingly, the embodiment of the invention is directed to changing the magnitude of the breakdown voltage by controlling the concentrations of impurities contained in the substrate in order not to cause the breakdown phenomenon even though the largest reverse-bias voltage is applied to one abnormal solar cell.

In consideration of the internal field which is changed by the reverse-bias voltage in the formation of the p-n junction, the concentrations of the impurities in the substrate for obtaining the breakdown voltage of about 12V and greater is discussed below. In an embodiment of the invention, the substrate is a substrate that is sliced from an ingot for manufacturing the solar cell.

The pure impurity concentration Ct of the sliced substrate for the solar cell is about $7.2 \times 10^{15}/\mathrm{cm}^3$ to $3.5 \times 10^{16}/\mathrm{cm}^3$. In this instance, the concentration of aluminum (Al) is about $1 \times 10^{13}/\mathrm{cm}^3$ to $5.5 \times 10^{15}/\mathrm{cm}^3$, the concentration (or the sum concentration) (C1+C3) of the concentration C1 of the p-type impurity such as boron (B) and the concentration C3 of at least one of aluminum (Al) and gallium (Ga) is about $3.5 \times 10^{16}/\mathrm{cm}^3$ or less. When the concentration (C1+C3) of the p-type impurities is $3.5 \times 10^{16}/\mathrm{cm}^3$ or less, the concentration C2 of phosphorous (P) which is the n-type impurity is about $2.8 \times 10^{16}/\mathrm{cm}^3$ or less. The concentration of iron (Fe) is about $6 \times 10^{15}/\mathrm{cm}^3$ or less.

When the pure impurity concentration Ct of the substrate is about $3.5 \times 10^{16}/\mathrm{cm}^3$ or less, the minimum value of the breakdown voltage is about 12V, and when the pure impurity concentration Ct of the substrate is about $7.2 \times 10^{15}/\mathrm{cm}^3$ or more, the substrate stably maintains the p-type (or the p-type characteristic).

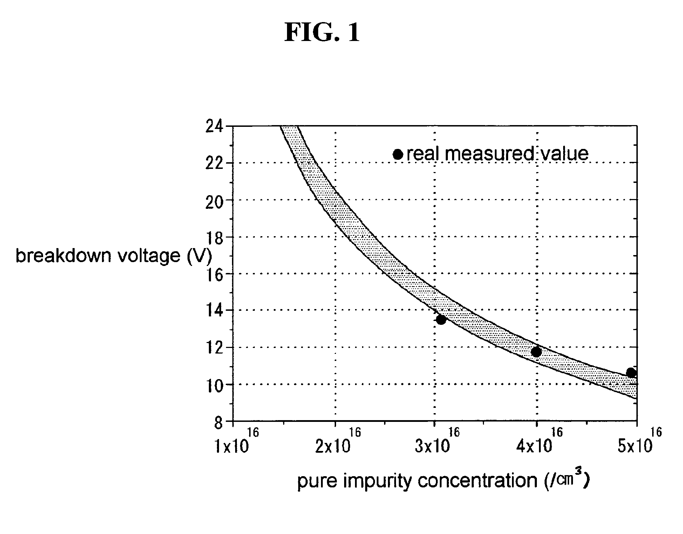

As described above, when a solar cell is manufactured using the substrate having the concentration of the p-type impurities and the concentration of the n-type impurities, a theoretical breakdown voltage with respect to the solar cell is as described with reference to FIG. 1.

FIG. 1 shows a range of the theoretical breakdown voltages with respect to the pure impurity concentrations, in the p-type polycrystalline silicon substrate having band gap energy of about 0.7eV to 0.76eV. The lowest limit of each theoretical breakdown voltage is a theoretical value in an instance that the polycrystalline silicon substrate has the band gap energy of about 0.7eV, and the uppermost limit of each theoretical breakdown voltage is a theoretical value in an instance that the polycrystalline silicon substrate has the band gap energy of about 0.76eV.

The theoretical breakdown voltage is calculated by [Equation 1].

[Equation 1]

$$E(x=0) = -\left[\frac{2q}{\epsilon Si}\left(\frac{NaNd}{Na+Nd}\right)(Vbi - Va)\right]^{\frac{1}{2}}$$

Here, E(x) is an internal field value, q is quantity of electric charge, that is, $1.6 \times 10^{19}$ (coulomb), Na is a pure impurity concentration, Nd is a doped concentration of an emitter region, Vbi is a built-in potential, εSi is permittivity of silicon and Va is a breakdown voltage.

In [Equation 1], the breakdown voltage (Va) is obtained by [Equation 2].

[Equation 2]

$$|Va| = E^2 \cdot \frac{\epsilon Si}{2q}\left(\frac{Na+Nd}{NaNd}\right) - Vbi$$

Here, E is an internal field value when a breakdown phenomenon occurs (that is, E is a breakdown field value).

In this instance, the breakdown field value E is a value corresponding about 75% to 80% of a theoretical breakdown field value.

The theoretical breakdown field value Ebr is calculated by [Equation 3].

[Equation 3]

$$|Ebr| = \frac{4 \times 10^5}{1 - \frac{1}{3}log(Na/10^{16})} \ V/cm$$

The theoretical breakdown field value Ebr is a field value theoretically calculated in an instance when a silicon substrate has ideal crystallinity and does not contain impurities.

However, a real polycrystalline substrate does not have the ideal breakdown field value Ebr due to a crystalline state (that is, crystallinity or imperfections therein) and impurities existing in the substrate, etc., but generally has a field value of about 75% to 80% of the ideal breakdown field Ebr calculated by [Equation 3]. Thus, the breakdown field value E is calculated as a value of 75% to 80% of the ideal breakdown field value Ebr. FIG. 1 is a graph of the theoretical breakdown voltages calculated by [Equation 3] and the calculated theoretical breakdown voltages are shown in [TABLE 1]

[TABLE 1]

| Na(/cm$^3$) | 6E+16 | 5E+16 | 4E+16 | 3.5E+16 | 3E+16 |
|---|---|---|---|---|---|
| Nd(/cm$^3$) | 1E+20 | 1E+20 | 1E+20 | 1E+20 | 1E+20 |
| Vbi(V) | 0.9929678 | 0.50873433 | 0.609815 | 0.7192898 | 0.880973623 |
| E$_{0.75}$(V/cm) | 405068.08 | 391129.1907 | 375322.2 | 366459.664 | 356735.3372 |
| E$_{0.8}$(V/cm) | 432072.62 | 417204.4701 | 400343.6 | 390890.309 | 380517.6931 |
| Va$_{0.75}$(V) | 7.9 | 8.9 | 10.4 | 11.4 | 12.7 |
| Va$_{0.8}$g(V) | 9.1 | 10.3 | 12.1 | 13.1 | 14.6 |

In [TABLE 1], E$_{0.75}$ represents breakdown field values corresponding to about 75% of the theoretical breakdown voltages, and E$_{0.8}$ represents breakdown field values corresponding to about 80% of the theoretical breakdown voltages.

In addition, Va$_{0.75}$ represents breakdown voltages calculated using E$_{0.75}$, and Va$_{0.8}$ represents breakdown voltages calculated using E$_{0.8}$.

When FIG. 1 and [TABLE 1] are calculated, it is realized that the breakdown voltage Va is about 12V or more, when the pure impurity concentration Na of the substrate is about $3.5 \times 10^{16}$/cm$^3$ or less. As described above, the pure impurity concentration is $7.2 \times 10^{15}$/cm$^3$ or less, portions of an n-type are partially generated in the substrate of the p-type. Thus, the pure impurity concentration should have $7.2 \times 10^{15}$/cm$^3$ or more, and in this instance, the breakdown voltage (Va) is about 41V. Accordingly, in this example, a region or a range of the breakdown voltage Va is about 12V to 41 V.

In FIG. 1, real measured values are breakdown voltages measured in a solar cell, after manufacturing of the solar cell that is made of p-type polycrystalline silicon using the substrate for the solar cell according to the embodiment of the invention. It is realized that when the substrate has the pure impurity concentration of $3.5 \times 10^{16}$/cm$^3$ or less in the real measured values, the breakdown voltage Va is 12V or more. When the substrate contains the impurities with the concentrations defined in the embodiment of the invention, the breakdown voltage has the minimum value of about 12V, and though the maximum reverse-bias voltage in a solar cell module having the plurality of solar cell arranged in the $10 \times 6$ matrix structure is applied to one abnormal solar cell, the breakdown phenomenon does not occur, and thereby lifetime of the solar cells and the solar cell module elongate and the efficiency of thereof is improved.

In manufacturing the substrate for the solar cell, amounts of materials each which contains the impurities such as boron (B), phosphorus (P), aluminum (Al), gallium (Ga) and iron (Fe) are adjusted, and thereby concentrations of the impurities of boron (B), phosphorus (P), aluminum (Al), gallium (Ga) and iron (Fe) may be controlled in desired (or described above) values.

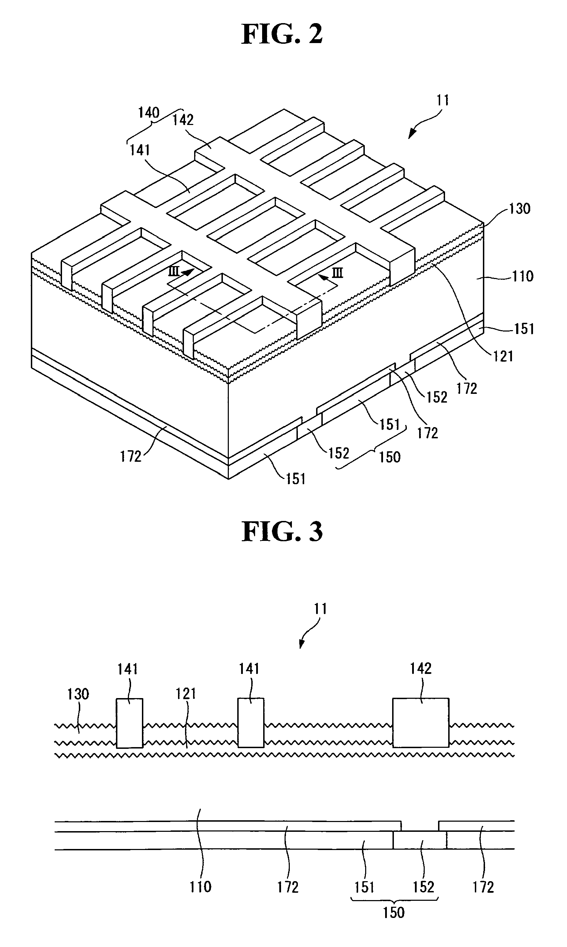

A structure of a solar cell manufactured using the substrate having the doped concentrations of the impurities and the pure impurity doped concentration as described above is described with reference to FIGS. 2 and 3.

As shown in FIGS. 2 and 3, a solar cell 11 according to an example embodiment of the invention includes a substrate 110, an emitter region 121 positioned at an incident surface (hereinafter, referred to as "a front surface") of the substrate 110 on which light is incident, an anti-reflection region 130 positioned on the emitter region 121, a front electrode part 140 connected to the emitter region 121, a back surface field region 172 positioned at a surface (hereinafter, referred to as "a back surface"), opposite the front surface of the substrate 110, on which light is not incident, and a back electrode part 150 positioned on the back surface of the substrate 110.

The substrate 110 is a semiconductor substrate formed of, for example, polycrystalline silicon of a first conductivity type, such as a p-type, though not required. When the substrate 110 is of the p-type, the substrate 110 may be doped with impurities of a group III element such as boron (B).

The front surface of the substrate 110 is textured to form a textured surface corresponding to an uneven surface or having uneven characteristics. FIG. 2 shows that only an edge of the substrate 110 and only an edge of the anti-reflection region 130 on the substrate 110 as having a plurality of uneven portions for the sake of brevity. However, the entire front surface of the substrate 110 is the textured surface having a plurality of projections, and thus the anti-reflection region 130 on the front surface of the substrate 110 has the textured surface having the plurality of uneven portions.

By the textured surface of the substrate 110 having the plurality of projections, the anti-reflection efficiency of light of the solar cell 11 increases and thereby, an amount of light incident on the substrate 110 increases.

The substrate 110 includes various impurities such as boron (B) for the p-type, at least one of aluminum (Al) and gallium (Ga) of the p-type, phosphorus (P), which is dopant of an n-type, iron (Fe) which does not affect the conductivity type of the substrate 110, and so on.

A pure impurity concentration of the substrate 110 according to the embodiment of the invention is about $10^{15}$/cm$^3$ to $3.5 \times 10^{16}$/cm$^3$. A concentration of aluminum (Al) contained in the substrate 110 is about $1 \times 10^{13}$/cm$^3$ to $5.5 \times 10^{15}$/cm$^3$. A sum concentration of a concentration of the p-type impurity such as boron (B), which is an impurity applied from an external source for the p-type of the substrate 110, in this instance, a concentration of phosphorous (P) contained in the substrate 110 and having the p-type impurity is about $2.8 \times 10^{16}$/cm or less. A concentration of iron (Fe) is about $6 \times 10^{15}$/cm$^3$ or less. The concentrations of the impurities are measured in a portion of the substrate 110, on which the emitter region 121 and the back surface field region 172 are not positioned. In the substrate 110 with the above concentrations of the impurities, a breakdown voltage of the solar cell 11 is about 12V to 14V.

The emitter region 121 is a region obtained by doping the substrate 110 with impurities of a second conductivity type (for example, n-type) opposite the first conductivity type (for example, p-type) of the substrate 110, so as to be an n-type semiconductor, for example. The emitter region 121 is positioned at the front surface of the substrate 110 on which light is incident. The emitter region 121 of the second conductivity type forms a p-n junction along with a first conductivity type region of the substrate 110.

By a built-in potential difference resulting from the p-n junction between the substrate 110 (or the first conductive type region of the substrate 110) and the emitter region 121, a plurality of electrons and a plurality of holes produced by light incident on the substrate 110 move to the n-type semiconductor and the p-type semiconductor, respectively. Thus, when the substrate 110 is of the p-type and the emitter region 121 is of the n-type, the holes move to the back surface of the substrate 110 and the electrons move to the emitter region 121.

The emitter region 121 may be formed by doping the substrate 110 with impurities of a group V element.

The anti-reflection region 130 positioned on the emitter region 121 is made of silicon nitride (SiNx) or silicon oxide (SiOx), etc. Other materials may be used for the anti-reflection region 130.

The anti-reflection region 130 reduces a reflectance of light incident on the solar cell 11 and increases selectivity of a predetermined wavelength band, thereby increasing the efficiency of the solar cell 11. In this embodiment of the invention, the anti-reflection region 130 has a single-layered structure, but the anti-reflection region 130 may have a multi-layered structure such as a double-layered structure in other embodiments. The anti-reflection region 130 may be omitted, if desired.

The front electrode part 140 includes a plurality of front electrodes 141 and a plurality of front bus bars 142 connected to the plurality of front electrodes 141.

The plurality of front electrodes 141 are electrically and physically connected to the first emitter region 121 and extend substantially parallel to one another in a predetermined direction at a distance therebetween. The plurality of front electrodes 141 collect carriers (e.g., electrons) moving to the emitter region 121.

The plurality of front bus bars 142 are electrically and physically connected to the emitter region 121 and extend substantially parallel to one another in a direction crossing an extending direction of the front electrodes 141.

The front electrodes 141 and the front bus bars 142 are placed on the same level layer (or are coplanar). The front electrodes 141 and the front bus bars 142 are electrically and physically connected to one another at crossings of the front electrodes 141 and the front bus bars 142.

As shown in FIG. 2, the plurality of front electrodes 141 have a stripe shape extending in a transverse or longitudinal direction, and the plurality of front bus bars 142 have a stripe shape extending in a longitudinal or transverse direction. Thus, the front electrode part 140 has a lattice shape on the front surface of the substrate 110.

The plurality of front bus bars 142 collect not only carriers transferred from a portion of the emitter region 121 contacting the plurality of front bus bars 142 but also the carriers collected by the plurality of front electrodes 141.

Because the plurality of front bus bars 142 collect the carriers collected by the plurality of front electrodes 141 and move the carriers to a desired location, a width of each of the plurality of front bus bars 142 is greater than a width of each of the plurality of front electrodes 141.

The plurality of front bus bars 142 are connected to an external device and output the carriers (for example, electrons) collected by the front bus bars 142 to the external device.

The front electrode part 140 including the plurality of front electrodes 141 and the plurality of front bus bars 142 is formed of at least one conductive material, for example, silver (Ag).

Although FIG. 2 shows a predetermined number of front electrodes 141 and a predetermined number of front bus bars 142 on the substrate 110, the number of front electrodes 141 and the number of front bus bars 142 may vary.

By the front electrode part 140 electrically and physically connected to the emitter region 121, the anti-reflection region 130 is positioned on portions of the emitter region 121, on which the front electrode part 140 is not positioned.

The back surface field region 172 is a region (for example, a p$^+$-type region) that is more heavily doped than the substrate 110 with impurities of the same conductivity type as the substrate 110.

A potential barrier is formed by a difference between impurity concentrations of a first conductivity region of the substrate 110 and the back surface field region 172. Hence, the potential barrier prevents or reduces electrons from moving to the back surface field region 172 used as a moving path of holes but facilitate the movement of charges (for example, holes) to the back surface field region 172. Thus, an amount of carriers lost by a recombination and/or a disappearance of the electrons and the holes at and around the back surface of the substrate 110 is reduced, and a movement of carriers to the back electrode part 150 increases by accelerating a movement of desired carriers (for example, holes).

The back electrode part 150 includes a back electrode 151 and a plurality of back bus bars 152 connected to the back electrode 151.

The back electrode 151 contacts the back surface field region 172 positioned at the back surface of the substrate 110 and is positioned on substantially the entire back surface of the substrate 110 except a formation area of the back bus bars 152. In an alternative example, the back electrode 151 may be not further positioned on an edge of the back surface of the substrate 110.

The back electrode 151 contains a conductive material such as aluminum (Al).

The back electrode 151 collects carriers (for example, holes) moving to the back surface field region 172.

Because the back electrode 151 contacts the back surface field region 172 having the impurity concentration higher than the substrate 110, a contact resistance between the substrate 110 (i.e., the back surface field region 172) and the back electrode 151 decreases. Hence, the carrier transfer efficiency from the substrate 110 to the back electrode 151 is improved.

The plurality of back bus bars 152 are positioned on the back surface of the substrate 110, on which the back electrode 151 is not positioned, and are connected to the back electrode 151.

Further, the plurality of back bus bars 152 are positioned opposite the plurality of front bus bars 142 with the substrate 110 therebetween. That is, the back bus bars 152 and the front bus bars 142 may be aligned, but such is not required.

The plurality of back bus bars 152 collect carriers from the back electrodes 151 in the same manner as the plurality of front bus bars 142.

The plurality of back bus bars 152 are connected to the external device and output the carriers (for example, holes) collected by the back bus bars 152 to the external device.

Since the plurality of back bus bars 152 outputs the carriers transferred from the back electrode 151 to the external device, the plurality of back bus bars 152 may be formed of a material having better conductivity than the back electrode 151. Thus, the plurality of back bus bars 152 may be made of a different material from the back electrode 151, and for example, the plurality of back bus bars 152 may contain at least one conductive material, for example, silver (Ag).

Alternatively, the back electrode 151 may further be positioned on portions of the back surface, on which the back bus bars 152 are positioned, and thereby the back electrode 151 may be positioned on the entire back surface of the substrate 110. In this instance, the back bus bars 152 may be positioned opposite the front bus bars 142 with the substrate 110 therebetween on the back electrode 151. In this instance, the back electrode 151 may be positioned on substantially the entire back surface of the substrate 110 except the edge of the back surface of the substrate 110, if necessary or desired.

An operation of the solar cell 11 having the above-described structure is described below.

When light irradiated to the solar cell 11 is incident on the emitter region 121 and the substrate 110 through the anti-reflection region 130, a plurality of electrons and a plurality of holes are generated in the emitter region 121 and the substrate 110 by light energy based on the incident light. In this instance, because a reflection loss of the light incident on the substrate 110 is reduced by the textured surface of the substrate 110 and the anti-reflection region 130, an amount of light incident on the substrate 110 further increases.

By the p-n junction of the substrate 110 and the emitter region 121, the electrons move to the n-type emitter region 121 and the holes move to the p-type substrate 110. The electrons moving to the n-type emitter region 121 are collected by the front electrodes 141 and the front bus bars 142 and then move to the front bus bars 142. The holes moving to the p-type substrate 110 are collected by the back electrodes 151 and the back bus bars 152 and then move to the back bus bars 152. When the front bus bars 142 are connected to the back bus bars 152 using electric wires, current flows therein to thereby enable use of the current for electric power.

Since the breakdown voltage of the solar cell 11 is about 12V and greater, the breakdown phenomenon of the solar cell 11 does not occur even though the maximum reverse-bias voltage of about 11.4V is applied to the solar cell 11,

## Claims

1. A semiconductor substrate for a solar cell made of a semiconductor of a p-type, the semiconductor comprising:

   a first impurity of the p-type;
   a second impurity of the p-type; and
   a third impurity of an n-type,
   wherein a pure p-type impurity concentration of the semiconductor substrate is substantially $7.2\times10^{15}/$ cm$^3$ to $3.5\times10^{16}/$cm$^3$, and
   the pure impurity concentration is obtained by subtracting a concentration of the third impurity from a sum of a concentration of the first impurity and a concentration of the second impurity.

2. The semiconductor substrate of claim 1, wherein the concentration of the second impurity is substantially $1\times10^{13}/$cm$^3$ to $5.5\times10^{15}/$cm$^3$.

3. The semiconductor substrate of claim 1, wherein the sum of the concentration of the first impurity and the concentration of the second impurity is substantially $3.5\times10^{16}/$cm$^3$ or less.

4. The semiconductor substrate of claim 1, wherein the concentration of the third impurity is substantially $2.8\times10^{16}/$cm$^3$ or less.

5. The semiconductor substrate of claim 1, wherein the first impurity is boron (B), the second impurity is at least one of aluminum (Al) and gallium (Ga), and the third impurity is phosphorus (P).

6. The semiconductor substrate of claim 1, wherein the semiconductor substrate is a polycrystalline silicon substrate.

7. The semiconductor substrate of claim 1, further comprising iron (Fe).

8. The semiconductor substrate of claim 7, wherein a concentration of the iron (Fe) is substantially $6\times10^{15}/$cm$^3$ or less.

9. A solar cell, comprising:

   a polycrystalline semiconductor substrate of a p-type;

an emitter region of an n-type and forming a p-n junction with the polycrystalline semiconductor substrate;
a first electrode connected to the emitter region; and
a second electrode connected to the polycrystalline semiconductor substrate,
wherein the polycrystalline semiconductor substrate has a pure p-type impurity concentration of substantially $7.2 \times 10^{15}/cm^3$ to $3.5 \times 10^{16}/cm^3$.

10. The solar cell of claim 9, wherein the solar cell has a breakdown voltage of substantially 12V to 41 V.

11. The solar cell of claim 9, wherein the polycrystalline semiconductor substrate includes:

a first impurity of the p-type;
a second impurity of the p-type; and
a third impurity of the n-type,
wherein the pure impurity concentration is obtained by subtracting a concentration of the third impurity from a sum of a concentration of the first impurity and a concentration of the second impurity.

12. The solar cell of claim 11, wherein the concentration of the second impurity is substantially $1 \times 10^{13}/cm^3$ to $5.5 \times 10^{15}/cm^3$.

13. The solar cell of claim 11, wherein the sum of the concentration of the first impurity and the concentration of the second impurity is substantially $3.5 \times 10^{16}/cm^3$ or less, and the concentration of the third impurity is substantially $2.8 \times 10^{16}/cm^3$ or less.

14. The solar cell of claim 11, wherein the first impurity is boron (B), the second impurity is at least one of aluminum (Al) and gallium (Ga), and the third impurity is phosphorus (P).

15. The solar cell of claim 11, wherein the polycrystalline semiconductor substrate further comprises iron (Fe), and a concentration of the iron (Fe) is substantially $6 \times 10^{15}/cm^3$ or less.

# FIG. 1

# FIG. 2

# FIG. 3